# EUROPEAN PATENT APPLICATION

(11) **EP 4 708 513 A1**
(43) Date of publication of application: **11.03.2026**
(21) Application number: 25753050.1
(22) Date of filing: 18.07.2025
(51) Int. Cl.: H01M 50/247, H01M 10/613, H01M 10/623, H05K 7/20, H01M 50/593, H01M 50/531, H01M 50/276, H01M 50/262, H04M 1/02

(54) **ELECTRONIC DEVICE COMPRISING BATTERY STRUCTURE FOR HEAT DISSIPATION**

(30) Priority: 19.07.2024 KR 20240095871 U; 30.08.2024 KR 20240118135 U
(71) Applicant: Samsung Electronics Co., Ltd, Suwon-si, Gyeonggi-do 16677 (KR)
(72) Inventor: PARK, Jungsik, Suwon-si, Gyeonggi-do 16677 (KR); KWAK, Woongeun, Suwon-si, Gyeonggi-do 16677 (KR); JU, Wanjae, Suwon-si, Gyeonggi-do 16677 (KR); HONG, Sukgi, Suwon-si, Gyeonggi-do 16677 (KR); NA, Hyoseok, Suwon-si, Gyeonggi-do 16677 (KR)
(74) Representative: Gulde & Partner
(86) International application number: PCT/KR2025/010657
(87) International publication number: WO 2026/019300

(57) **Abstract**

According to an embodiment, an electronic device includes a printed circuit board including an electronic component and a battery. The battery includes a metal can case including a plate and a cover formed from a first metal material, and an electrode assembly disposed in the metal can case. The plate includes a first layer formed from a second metal material, and a second layer, formed from at least the first metal material, disposed on the first layer, and facing the electrode assembly. Heat conductivity of the second metal material is greater than heat conductivity of the first metal material, for dissipating heat, generated by the electronic component, transmitted through a heat-conductive member by thermally contacting with the plate.

## Description

### [Technical Field]

The present disclosure relates to an electronic device including a battery structure for dissipating heat.

### [Background Art]

An electronic device may include electronic components for providing various functions of the electronic device. The electronic device may include a battery for providing power to the electronic components. As the electronic device is driven, heat may be generated from the electronic components.

The above-described information may be provided as a related art for the purpose of helping understanding of the present disclosure. No claim or determination is raised as to whether any of the above-described descriptions may be applied as an art related to the present disclosure.

### [Disclosure]

### [Technical Solution]

An electronic device is disclosed. The electronic device may comprise a printed circuit board (PCB) including an electronic component, and a battery. The battery may include a metal can case including a plate and a cover formed from a first metal material, and an electrode assembly disposed within the metal can case. The plate may include a first layer formed from a second metal material, and a second layer, formed from at least the first metal material, disposed on the first layer, and facing the electrode assembly. Heat conductivity of the second metal material may be greater than heat conductivity of the first metal material, for dissipating heat, generated by the electronic component, transmitted through a heat-conductive member by thermally contacting with the plate.

An electronic device is disclosed. The electronic device may include a heat generating component, a bracket disposed on the heat generating component, and a battery spaced apart from the heat generating component. The battery may include a case fastened to the bracket, an electrode assembly including one or more first electrodes disposed in the case, and one or more second electrodes having different polarity with respect to the one or more first electrodes, a first tab extending from the one or more first electrodes of the electrode assembly, through the case, to the outside of the battery, a second tab extending from the one or more second electrodes of the electrode assembly, through the case, to the outside of the battery, and an insulation cover, disposed within the case, including a first through hole penetrated by the first tab and a second through hole, penetrated by the second tab, spaced apart from the first through hole. The insulation cover may electrically disconnect the first tab and the second tab from the case.

An electronic device is disclosed. The electronic device may include a heat generating component, a bracket disposed on the heat generating component, and a battery spaced apart from the heat generating component. The battery may include a case including a first plate facing the bracket and a second plate coupled to the first plate, and an electrode assembly disposed within the case. Heat conductivity of the first plate may be greater than heat conductivity of the second plate. The first plate may include a first metal layer at least partially forming an outer surface of the case, a second metal layer at least partially forming an inner surface of the case, and a third metal layer disposed between the first metal layer and the second metal layer. Heat conductivity of the third metal layer may be greater than the heat conductivity of the first metal layer and the heat conductivity of the second metal layer. However, it is not limited thereto, and the first plate may be composed of a single layer for weight reduction, or may include a structure in which any one of the first metal layer, the second metal layer, and/or the third metal layer is omitted. For example, the second metal layer contacting the second plate may have substantially the same melting point during welding or may be substantially the same material to facilitate welding of two metals forming the second plate and the second metal layer, respectively. In case that the two metals are different materials, a coating may be formed on at least one of the two metals.

### [Brief Description of the Drawings]

FIG. 1 is a block diagram of an electronic device in a network environment according to various embodiments.
FIG. 2 is a block diagram with respect to a power management module and a battery of an exemplary electronic device.
FIG. 3A is a diagram illustrating an exemplary electronic device.
FIG. 3B is an exploded perspective view of an exemplary electronic device.
FIG. 4A illustrates a portion of an exemplary electronic device.
FIGS. 4B and 4C illustrate a battery of an exemplary electronic device.
FIG. 5 is a partial cross-sectional view of an exemplary electronic device cut along line A-A' of FIG. 4A.
FIG. 6A is a top plan view of a battery of an exemplary electronic device.
FIGS. 6B, 6C, 6D, and 6E illustrate an internal structure of an exemplary electronic device.

### [Detailed Description of the Drawings]

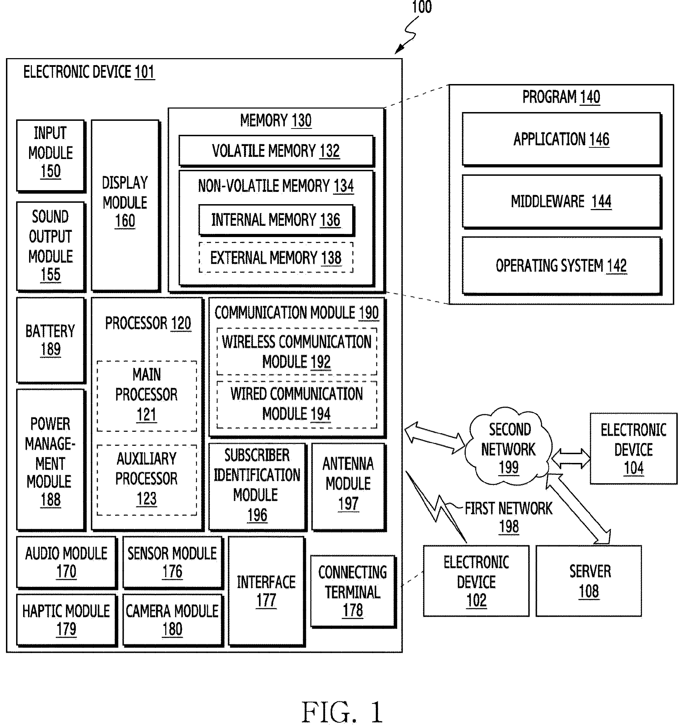

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. Also, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

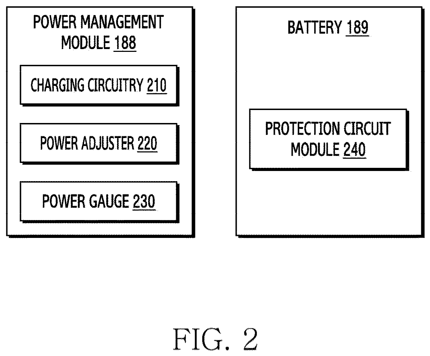

FIG. 2 is a block diagram with respect to a power management module and a battery of an exemplary electronic device.

Referring to FIG. 2, a power management module 188 may include charging circuitry 210, a power adjuster 220, or a power gauge 230. The charging circuitry 210 may charge a battery 189 using power supplied from an external power source for an electronic device 101. According to an embodiment, the charging circuitry 210 may select a charging method (e.g., normal charging or quick charging) based on at least a portion of a type (e.g., a power adapter, USB or wireless charging) of an external power source, magnitude (e.g., more than about 20 watts) of power that may be supplied from the external power source, or a property of the battery 189, and charge the battery 189 using the selected charging method. The external power source may be, for example, wire-connected to the electronic device 101 through a connection terminal 178, or wirelessly connected through an antenna module 197.

The power adjuster 220 may generate, for example, a plurality of powers having different voltages or different current levels by adjusting a voltage level or a current level of the power supplied from the external power source or battery 189. The power adjuster 220 may adjust the power of the external power source or the battery 189 to a voltage or a current level suitable for each or some components among the components included in the electronic device 101. According to an embodiment, the power adjuster 220 may be implemented in a form of a low-dropout (LDO) regulator or a switching regulator. The power gauge 230 may measure usage state information (e.g., a capacity, the number of charge/discharge cycles, voltage, or a temperature of the battery 189).

The power management module 188 may, for example, determine charging state information (e.g., lifespan, overvoltage, low voltage, overcurrent, overcharge, overdischarge, overheating, short circuit, or swelling) associated with charging of the battery 189 based at least in part on the measured usage state information, by using the charging circuitry 210, the power adjuster 220, or the power gauge 230. The power management module 188 may determine whether the battery 189 state is normal or abnormal based at least in part on the determined charging state information. In case of determining that the state of the battery 189 is abnormal, the power management module 188 may adjust (e.g., reduce a charging current or voltage, or cease to charge) the charging with respect to the battery 189. According to an embodiment, at least a portion of functions of the power management module 188 may be performed by an external control device (e.g., a processor 120).

The battery 189 may include a protection circuit module (PCM) 240. The protection circuit module 240 may perform one or more among various functions (e.g., a pre-blocking function) for preventing performance degradation and/or a damage by fire of the battery 189. Additionally or alternatively, the protection circuit module 240 may be configured as at least a portion of a battery management system (BMS) capable of performing various functions, including cell balancing, measuring battery capacity, measuring the number of charges and discharges, measuring temperature, or measuring voltage.

For example, at least a portion of the usage state information or the charging state information of the battery 189 may be measured using a corresponding sensor (e.g., a temperature sensor) among a sensor module 276, the power gauge 230, or the power management module 188. For example, the corresponding sensor (e.g., the temperature sensor) among the sensor module 176 may be included as a portion of the protection circuit module 240, or may be disposed near the battery 189 as a separate device. However, an embodiment supported by the present disclosure is not limited thereto.

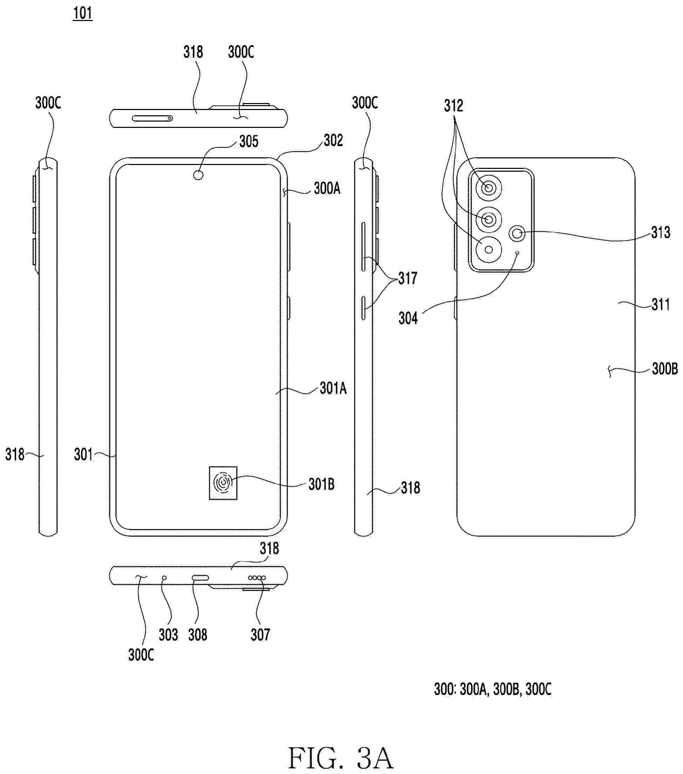

FIG. 3A is a diagram illustrating an exemplary electronic device.

Referring to FIG. 3A, an electronic device 101 may include a housing 300 forming an exterior of the electronic device 101. For example, the housing 300 may include a front surface 300A, a rear surface 300B, and a side surface 300C surrounding a space between the front surface 300A and the rear surface 300B. The housing 300 may refer to a structure forming at least a portion of the front surface 300A, the rear surface 300B, and/or the side surface 300C.

The electronic device 101 may include a substantially transparent front plate 302. The front plate 302 may form at least a portion of the front surface 300A. The front plate 302 may include, for example, a glass plate or a polymer plate that includes various coating layers, but is not limited thereto.

The electronic device 101 may include a substantially opaque rear plate 311. The rear plate 311 may form at least a portion of the rear surface 300B. The rear plate 311 may be formed by coated and/or colored glass, ceramic, polymer, metal (e.g., aluminum, stainless steel (STS), or magnesium), or a combination of at least two of the materials.

The electronic device 101 may include a side bezel structure (or a side surface member) 318. The side bezel structure 318 may form at least a portion of the side surface 300C of the electronic device 101 by being coupled with the front plate 302 and/or the rear plate 311. For example, the side bezel structure 318 may form the entire side surface 300C of the electronic device 101, and for another example, the side bezel structure 318 may form the side surface 300C of the electronic device 101 together with the front plate 302 and/or the rear plate 311.

Unlike the illustrated example, in case that the side surface 300C of the electronic device 101 is partially formed by the front plate 302 and/or the rear plate 311, the front plate 302 and/or the rear plate 311 may include an area that is bent toward the rear plate 311 and/or the front plate 302 at its periphery and seamlessly extends. The extended area of the front plate 302 and/or the rear plate 311 may be positioned, for example, at both ends of a long edge of the electronic device 101, but is not limited by the above-described example.

The side bezel structure 318 may include a metal and/or a polymer. The rear plate 311 and the side bezel structure 318 may be integrally formed and may include the same material (e.g., a metallic material such as aluminum), but are not limited thereto. For example, the rear plate 311 and the side bezel structure 318 may be formed in separate configurations and/or may include different materials.

The electronic device 101 may include at least one of a display 301, audio modules 303, 304, and 307, a sensor module (not illustrated), camera modules 305, 312, and 313, a key input device 317, a light emitting element (not illustrated), and/or a connector hole 308. The electronic device 101 may omit at least one (e.g., the key input device 317 or the light emitting element (not illustrated)) of the components, or may further include another component.

The display 301 may be visually exposed through a significant portion of the front plate 302. For example, at least a portion of the display 301 may be visible through the front plate 302 forming the front surface 300A. The display 301 may be disposed on a back surface of the front plate 302.

An outer shape of the display 301 may be formed substantially the same as an outer shape of the front plate 302 adjacent to the display 301. In order to expand an area in which the display 301 is visually exposed, a distance between an outer periphery of the display 301 and an outer periphery of the front plate 302 may be formed substantially the same.

The display 301 (or the front surface 300A of the electronic device 101) may include a screen display area 301A. The display 301 may provide visual information to a user through the screen display area 301A. In the illustrated example, it is described that the screen display area 301A is positioned inside the front surface 300A by being spaced apart from an outer periphery of the front surface 300A, when the front surface 300A is viewed from the front, but is not limited thereto. In an embodiment, when the front surface 300A is viewed from the front, at least a portion of a periphery part of the screen display area 301A may substantially coincide with a periphery part of the front surface 300A (or the front plate 302).

The screen display area 301A may include a sensing area 301B configured to obtain biometric information of the user. Herein, the meaning of "the screen display area 301A includes the sensing area 301B" may be understood as that at least a portion of the sensing area 301B overlaps the screen display area 301A. For example, like another area of the screen display area 301A, the sensing area 301B may mean an area capable of displaying visual information by the display 301 and additionally obtaining the biometric information (e.g., a fingerprint) of the user. The sensing area 301B may be formed in the key input device 317.

The display 301 may include an area where the first camera 305 is positioned. An opening may be formed in the area of the display 301, and the first camera 305 (e.g., a punch hole camera) may be at least partially disposed in the opening to face the front surface 300A. In this case, the screen display area 301A may surround at least a portion of a periphery part of the opening. The first camera 305 (e.g., an under display camera (UDC) may be disposed under the display 301 to overlap the area of the display 301. In this case, the display 301 may provide visual information to the user through the area, and additionally, the first camera 305 may obtain an image corresponding to a direction facing the front surface 300A through the area of the display 301.

The display 301 may be combined with or disposed adjacent to touch sensing circuitry, a pressure sensor capable of measuring intensity (a pressure) of a touch, and/or a digitizer that detects a magnetic field type stylus pen.

The audio modules 303, 304, and 307 may include microphone holes 303 and 304 and a speaker hole 307.

The microphone holes 303 and 304 may include a first microphone hole 303 formed in a partial area of the side surface 300C and a second microphone hole 304 formed in a partial area of the rear surface 300B. A microphone (not illustrated) for obtaining external sound may be disposed inside the microphone holes 303 and 304. The microphone may include a plurality of microphones to detect a direction of sound.

The second microphone hole 304 formed in the partial area of the rear surface 300B may be disposed adjacent to the camera modules 305, 312, and 313. For example, the second microphone hole 304 may obtain sound according to an operation of the camera modules 305, 312, and 313. However, it is not limited thereto.

The speaker hole 307 may include an external speaker hole 307 and a call receiver hole (not illustrated). The external speaker hole 307 may be formed on a portion of the side surface 300C of the electronic device 101. The external speaker hole 307 and the microphone hole 303 may be implemented as one hole. Although not illustrated, the call receiver hole (not illustrated) may be formed on another portion of the side surface 300C. For example, the call receiver hole may be formed on an opposite side of the external speaker hole 307 at the side surface 300C. For example, based on the illustration of FIG. 3A, the external speaker hole 307 may be formed on the side surface 300C corresponding to a lower end of the electronic device 101, and the call receiver hole may be formed on the side surface 300C corresponding to an upper end of the electronic device 101. However, it is not limited thereto, and the call receiver hole may be formed at a position other than the side surface 300C. For example, the call receiver hole may be formed by a space separated between the front plate 302 (or the display 301) and the side bezel structure 318.

The electronic device 101 may include at least one speaker (not illustrated) configured to output sound to the outside of the housing through the external speaker hole 307 and/or the call receiver hole (not illustrated).

The sensor module (not illustrated) may generate an electrical signal or a data value corresponding to an operating state inside the electronic device 101 or an external environmental state. For example, the sensor module may include at least one of a proximity sensor, a heart rate monitor, HRM, sensor, a fingerprint sensor, a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 305, 312, and 313 may include a first camera 305 disposed to face the front surface 300A of the electronic device 101, a second camera 312 disposed to face the rear surface 300B, and a flash 313.

The second camera 312 may include a plurality of cameras (e.g., a dual camera, a triple camera, or a quad camera). However, the second camera 312 is not limited to including the plurality of cameras, and may include one camera.

The first camera 305 and the second camera 312 may include one or a plurality of lenses, an image sensor, and/or an image signal processor.

The flash 313 may include, for example, a light emitting diode or a xenon lamp. Three or more lenses (an infrared camera, and wide-angle and telephoto lenses) and image sensors may be disposed on a surface of the electronic device 101.

The key input device 317 may be disposed on the side surface 300C of the electronic device 101. The electronic device 101 may not include some or all of the key input device 317, and the key input device 317 that is not included may be implemented in another form, such as a soft key, on the display 301.

The connector hole 308 may be formed on the side surface 300C of the electronic device 101 to accommodate a connector of an external device. A connection terminal electrically connected to the connector of the external device may be disposed in the connector hole 308. The electronic device 101 may include an interface module for processing an electrical signal transmitted and received through the connection terminal.

The electronic device 101 may include the light emitting element (not illustrated). For example, the light emitting element (not illustrated) may be disposed on the front surface 300A of the housing. The light emitting element (not illustrated) may provide state information of the electronic device 101 in an optical form. The light emitting device (not illustrated) may provide a light source linked with an operation of the first camera 305. For example, the light emitting element (not illustrated) may include an LED, an IR LED, and/or a xenon lamp.

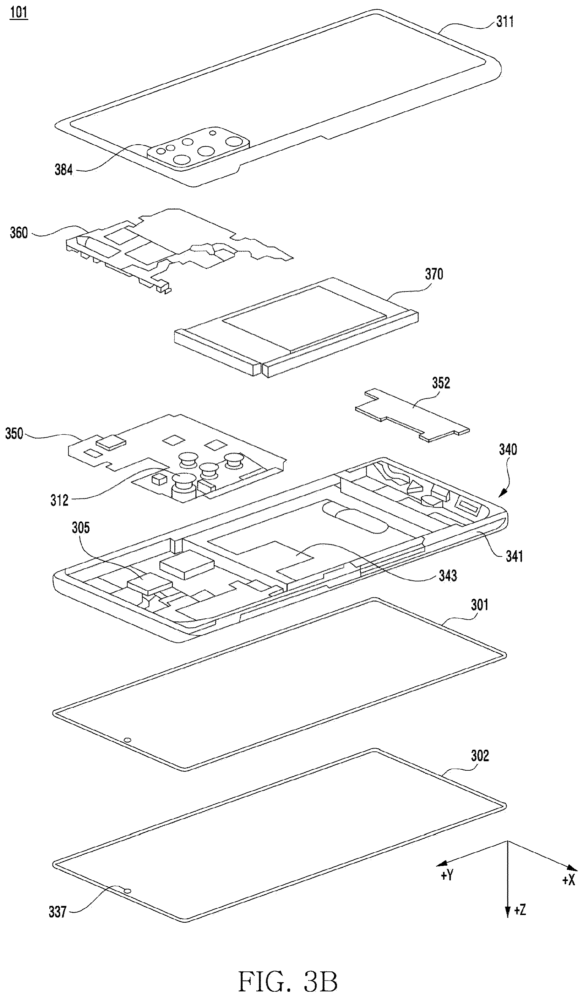

FIG. 3B is an exploded perspective view of an exemplary electronic device.

Hereinafter, overlapping descriptions of a configuration having the same reference numerals as the above-described configuration will be omitted.

Referring to FIG. 3B, the electronic device 101 may include a frame structure 340, a first printed circuit board 350, a second printed circuit board 352, a cover plate 360, and a battery 370.

The frame structure 340 may include the side bezel structure 318 forming the exterior (e.g., the side surface 300C of FIG. 3A) of the electronic device 101 and a supporting portion 343 extending inward from the side bezel structure 318. The frame structure 340 may be disposed between the display 301 and the rear plate 311. The side bezel structure 318 of the frame structure 340 may surround a space between the rear plate 311 and the front plate 302 (and/or the display 301) and the supporting portion 343 of the frame structure 340 may extend from the side bezel structure 318 within the space.

The frame structure 340 may support or accommodate other components included in the electronic device 101. For example, the display 301 may be disposed on a surface of the frame structure 340 facing a direction (e.g., a +z direction), and the display 301 may be supported by the supporting portion 343 of the frame structure 340. For example, the first printed circuit board 350, the second printed circuit board 352, the battery 370, and the second camera 312 may be disposed on another surface of the frame structure 340 facing an opposite direction (e.g., a -z direction) to the direction. The first printed circuit board 350, the second printed circuit board 352, the battery 370, and the second camera 312 may be respectively mounted to a recess defined by the side bezel structure 318 and/or the supporting portion 343 of the frame structure 340.

The first printed circuit board 350, the second printed circuit board 352, and the battery 370 may be respectively coupled with the frame structure 340. For example, the first printed circuit board 350 and the second printed circuit board 352 may be fixedly disposed on the frame structure 340 through a coupling member such as a screw. For example, the battery 370 may be fixedly disposed on the frame structure 340 through an adhesive member (e.g., a double-sided tape). In other words, the battery 370 may be adhered, fastened, or otherwise affixed to the frame structure 340 using an adhesive, mechanical, or chemical attachment method. However, it is not limited by the above-described example.

The cover plate 360 may be disposed between the first printed circuit board 350 and the rear plate 311. The cover plate 360 may be disposed on the first printed circuit board 350. For example, the cover plate 360 may be disposed on a surface of the first printed circuit board 350 facing the -z direction.

The cover plate 360 may at least partially overlap the first printed circuit board 350 with respect to the z-axis. In other words, when viewing the device along the z-axis from the side of the first printed circuit board 350, with the line of sight perpendicular to both the cover plate 360 and the first printed circuit board 350, the first printed circuit board 350 will obstruct at least part of the cover plate 360. The cover plate 360 may cover at least a partial area of the first printed circuit board 350. Through this, the cover plate 360 may protect the first printed circuit board 350 from physical impact or prevent the connector coupled to the first printed circuit board 350 from being separated.

The cover plate 360 may be fixedly disposed on the first printed circuit board 350 through the coupling member (e.g., the screw), or may be coupled to the frame structure 340 together with the first printed circuit board 350 through the coupling member.

The display 301 may be disposed between the frame structure 340 and the front plate 302. For example, the front plate 302 may be disposed on a side (e.g., the +z direction) of the display 301, and the frame structure 340 may be disposed on another side (e.g., the -z direction).

The front plate 302 may be coupled with the display 301. The front plate 302 and the display 301 may be adhered to each other through an optical adhesive member (e.g., optically clear adhesive (OCA) or optically clear resin (OCR)) interposed therebetween.

The front plate 302 may be coupled with the frame structure 340. For example, the front plate 302 may include an outer portion extending outside the display 301, when viewed in the z-axis direction, and may be attached to the frame structure 340 through the adhesive member (e.g., double-sided tape) disposed between the outer portion of the front plate 302 and the frame structure 380. However, it is not limited by the above-described example.

A processor, memory, and/or an interface may be mounted on the first printed circuit board 350 and/or the second printed circuit board 352. The processor may include, for example, one or more of a central processing unit, an application processor, a graphics processing unit, an image signal processor, a sensor hub processor, or a communication processor. The memory may include, for example, volatile memory or non-volatile memory. The interface may include, for example, a high definition multimedia interface (HDMI), a universal serial bus (USB), an SD card interface, and/or an audio interface. The interface may electrically and/or physically connect the electronic device 101 to an external electronic device, and may include a USB connector, an SD card/MMC connector, or an audio connector. The first printed circuit board 350 and the second printed circuit board 352 may be operatively and/or electrically connected with each other through a connection member (e.g., a flexible printed circuit board).

The battery 370 may supply power to at least one component of the electronic device 101. For example, the battery 370 may include a rechargeable secondary battery or a fuel cell. At least a portion of the battery 370 may be disposed on/in substantially the same plane as the first printed circuit board 350 and/or the second printed circuit board 352.

The electronic device 101 may include an antenna module (not illustrated). The antenna module may be disposed between the rear plate 311 and the battery 370. The antenna module may include, for example, a near field communication (NFC) antenna, a wireless charging antenna, and/or a magnetic secure transmission (MST) antenna. The antenna module may perform, for example, short-range communication with an external device or wirelessly transmit and receive power to and from the external device.

The first camera 305 (e.g., a front camera) may be disposed on at least a portion (e.g., the supporting portion 343) of the frame structure 340 so that a lens may receive external light through a partial portion (e.g., a camera area 337) of the front plate 302 (e.g., the front surface 300A of FIG. 3A).

The second camera 312 (e.g., a rear camera) may be disposed between the frame structure 340 and the rear plate 311. The second camera 312 may be electrically connected to the first printed circuit board 350 through a connection member (e.g., a connector). The second camera 312 may be disposed so that a lens may receive external light through a camera area 384 of the rear plate 311 of the electronic device 101.

The camera area 384 may be formed on a surface (e.g., the rear surface 300B of FIG. 3A) of the rear plate 311. The camera area 384 may be formed to be at least partially transparent so that external light may be incident on the lens of the second camera 312. At least a portion of the camera area 384 may protrude from the surface of the rear plate 311 to a predetermined height. However, it is not limited thereto, and the camera area 384 may form substantially the same plane as the surface of the rear plate 311.

A housing (e.g., the housing 300 of FIG. 3A) of the electronic device 101 may mean a configuration of structures or a structure forming at least a portion of the exterior of the electronic device 101. In this regard, at least a portion of the front plate 302, the frame structure 340, and/or the rear plate 311 forming the exterior of the electronic device 101 may be referred to as the housing 300 of the electronic device 101.

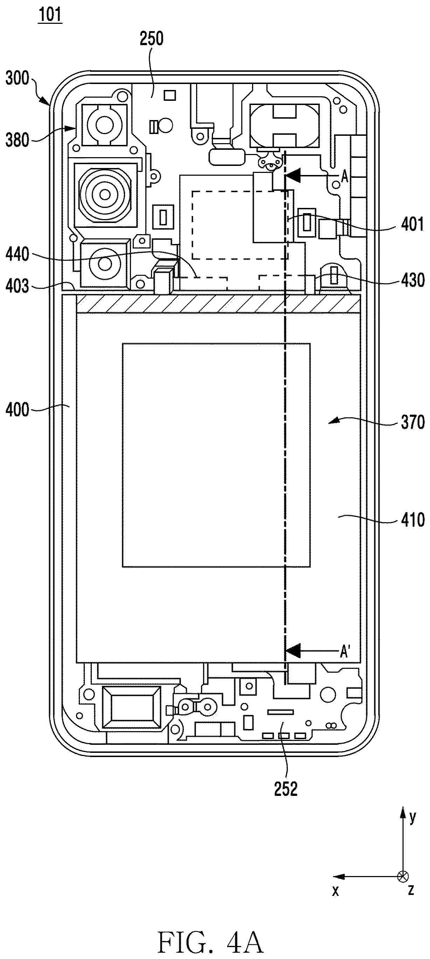

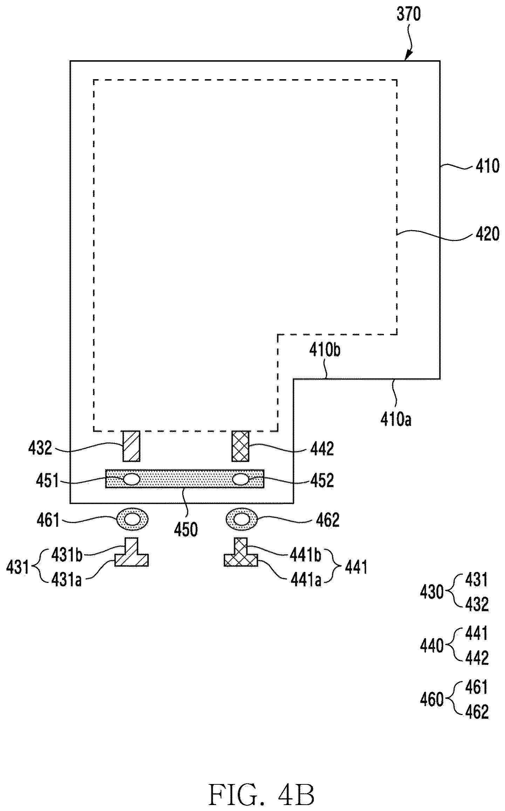

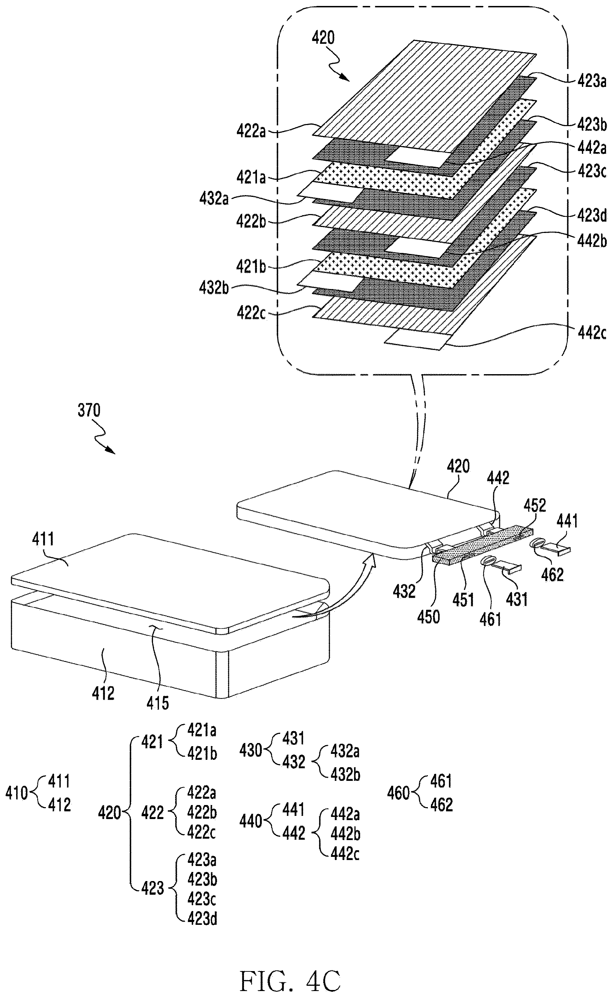

FIG. 4A illustrates a portion of an exemplary electronic device. FIGS. 4B and 4C illustrate a battery of an exemplary electronic device.

Referring to FIGS. 4A, 4B, and 4C, an electronic device 101 may include an electronic component 401, a bracket 400 (e.g., the frame structure 340 of FIG. 3B), and a battery 370.

The bracket 400 may support a display (e.g., the display 301 of FIG. 3A) of the electronic device 101 and/or structures disposed under the display 301 to support the display 301. The bracket 400 may form, for example, at least a portion of an exterior of the housing 300. For example, the bracket 400 may provide a space for accommodating electronic components in the electronic device 101. At least a portion of the electronic components may be electrically connected with the display 301. For example, the bracket 400 may include aluminum or titanium, but an embodiment supported in the present disclosure is not limited thereto.

For example, at least a portion of the bracket 400 may be disposed under the display 301 of the electronic device 101. For example, on the bracket 400, at least a portion of the electronic components of the electronic device 101 may be mounted or disposed. For example, the bracket 400 may define a surface that faces the display 301 and another surface opposite to the surface. A portion (e.g., the battery 370, or printed circuit boards 350, and 352) of the electronic components, for example such components that are bulky relative to other components of the electronic device 101 may be disposed on the other surface of the bracket 400 for the display 301. For example, the bracket 400 may include a peripheral portion (or the side bezel structure 318 of FIG. 3A) surrounding the electronic components of the electronic device 101. However, the embodiment supported in the present disclosure is not limited thereto.

The bracket 400 may include a partition wall 403. For example, the partition wall 403 protrudes from the bracket 400 to partition a space for accommodating the electronic components. For example, the partition wall 403 may support the battery 370 by contacting the battery 370. The partition wall 403 may reduce a movement of the battery 370 or a separation from the bracket 400 due to external impact, by supporting the battery 370. For example, the partition wall 403 may be at least partially disposed between the battery 370 and the first printed circuit board 350. The battery 370 may be isolated or separated from the first printed circuit board 350 by the partition wall 403. However, the embodiment supported in the present disclosure is not limited thereto.

The battery 370 may be mounted on or attached to the bracket 400. The battery 370 may be supported by the bracket 400. The battery 370 may be disposed in an inner space of the housing 300 formed by the bracket 400 (or the partition wall 403). For example, since the battery 370 has a relatively large volume, it may be attached to another surface opposite to a surface facing the display 301 of the bracket 400. For example, the battery 370 may be configured to be rechargeable for driving the electronic device 101 and/or the electronic components in the electronic device 101. However, the embodiment supported in the present disclosure is not limited thereto.

The first printed circuit board 350 may be disposed on the bracket 400. Electronic components for driving and/or executing a function of the electronic device 101 may be coupled to the first printed circuit board 350. For example, the first printed circuit board 350 may be disposed on the bracket 400 together with the battery 370. For example, the first printed circuit board 350 may be connected with the battery 370 to supply power to the electronic device 101 and/or the electronic components inside the electronic device 101, through the battery 370. For example, a power management integrated circuit (PMIC) (or the power management module 188 of FIG. 1) in the first printed circuit board 350 may be connected with the battery 370 through a flexible printed circuit board (FPCB) for power supplying of the electronic device 101. For example, the first printed circuit board 350 may be disposed adjacent to the battery 370 for the connection with the battery 370. The first printed circuit board 350 may be, for example, disposed on a surface of the bracket 400 together with the battery 370. For example, the first printed circuit board 350 may be disposed along the battery 370 or next to the battery 370. However, the embodiment supported in the present disclosure is not limited thereto.

According to an embodiment, the second printed circuit board 352 may be mounted on the bracket 400. The second printed circuit board 352 may be, for example, spaced apart from the first printed circuit board 350. For example, the second printed circuit board 352 may be disposed along the battery 370 or next to the battery 370. For example, the battery 370 may be disposed between the first printed circuit board 350 and the second printed circuit board 352. However, the embodiment supported in the present disclosure is not limited thereto, and the second printed circuit board 352 may be omitted.

The electronic component 401 disposed on the first printed circuit board 350 may emit (transfer) heat while the electronic device 101 is being driven. For example, the electronic component 401 may be a processor (e.g., the processor 120 of FIG. 1) of the electronic device 101 with a relatively high amount of heat generation. For example, the electronic component 401 may be disposed on a surface of the first printed circuit board 350. A camera module 380 (e.g., the camera module 180 of FIG. 1 or the rear cameras 312 and 313 of FIG. 3A) coupled to the first printed circuit board 350 may be disposed such that cameras (e.g., the second camera 312 and/or the flash 313 of FIG. 3A) disposed on the camera module 380 face an opposite direction (e.g., the -z axis direction of FIG. 3B) of the bracket 400. For example, the electronic component 401 may perform data processing or calculation according to an operation of the electronic device 101. The electronic component 401 may emit (transfer) heat around the electronic component 401 as the data processing or the calculation is performed. The electronic component 401 may be referred to as a heat generating component or a heat generating body in that it is an element generating the heat, but the embodiment supported in the present disclosure is not limited thereto. In the electronic device 101, a heat dissipation structure using the battery 370 may be required to reduce damage to the electronic component 401 and/or one or more other electronic components around the electronic component 401 due to the heat emitted (transferred) from the electronic component 401.

According to an embodiment, the battery 370 may be spaced apart from the electronic component 401. The battery 370 may include a case 410 fastened to the bracket 400 and an electrode assembly 420 disposed within the case 410.

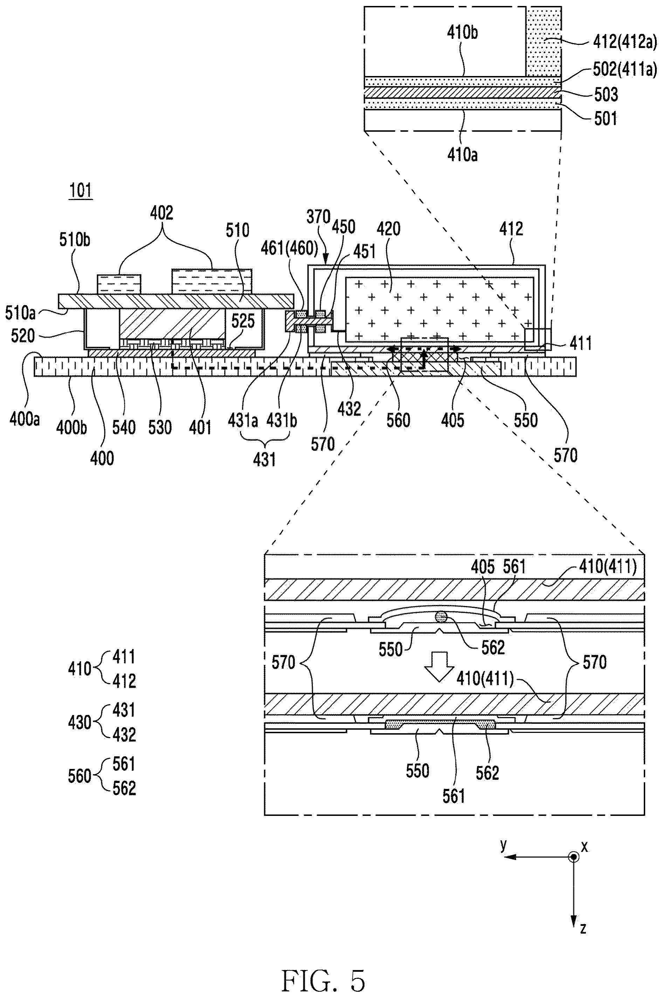

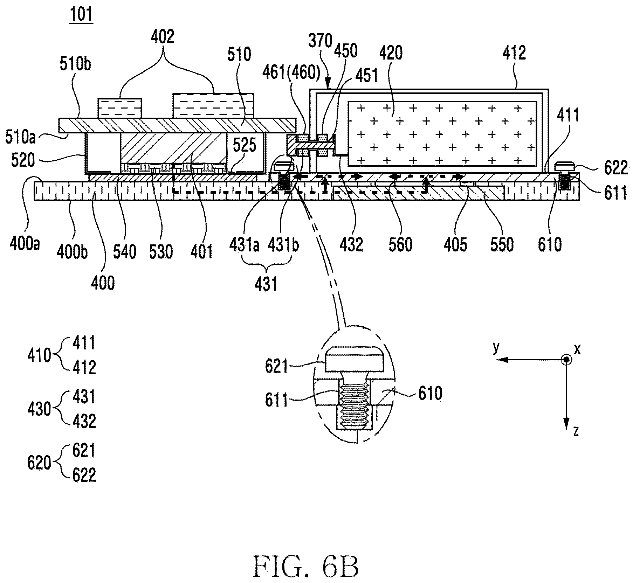

The case 410 may form an exterior of the battery 370. For example, the case 410 may accommodate internal components (e.g., the electrode assembly 420) of the battery 370. The case 410 may protect the internal components of the battery 370 disposed within the case 410 from external impact. For example, the case 410 may be removably coupled to the bracket 400 (e.g., through a fastener 620 of FIG. 6B) or removably attached to the bracket (400 (e.g., through an adhesive member 570 of FIG. 5). For example, the case 410 may receive at least a portion of the heat transmitted from the electronic component 401 to the bracket 400, from the bracket 400 by being fastened to the bracket 400. The case 410 may function as a heat sink or a heat dissipation structure of the electronic component 401 by dispersing the at least a portion of the heat. For example, as illustrated in FIG. 4C, the case 410 may be a pouch type case, but the embodiment supported in the present disclosure is not limited thereto, and for example, the case 410 may include a cylindrical type case or a prismatic type case.

For example, the case 410 may include a first plate 411 facing the bracket 400, and a second plate 412 coupled to the first plate 411. For example, the first plate 411 may be a portion of the case 410 attached on the bracket 400 or coupled to the bracket 400. For example, the second plate 412 may have a recess 415 for accommodating the electrode assembly 420 of the battery 370. The second plate 412 may surround the electrode assembly 420 together with the first plate 411 by being coupled on the first plate 411. However, the embodiment supported in the present document is not limited thereto. For example, although not illustrated in FIG. 5, in the second plate 412 of the case 410, holes for passing lead tabs 431 and 441 connected with electrode tabs 432 and 442 extending from the electrode assembly 420, may be formed. Through the holes, tabs 430 and 440 of the battery 370 may be drawn out to the outside of the battery 370 through an insulation cover 450. However, the embodiment supported in the present disclosure is not limited thereto.

The electrode assembly 420 may include a plurality of electrodes for supplying power to the electronic device 101 (or the electronic components in the electronic device 101). For example, the electrode assembly 420 may include one or more first electrodes 421 and one or more second electrodes 422 having different polarity with respect to the one or more first electrodes 421. For example, the electrode assembly 420 may include one or more separators 423 interposed between the one or more first electrodes 421 and the one or more second electrodes 422. For example, the one or more first electrodes 421 may be referred to as anodes of the electrode assembly 420. The one or more second electrodes 422 may be referred to as cathodes having different polarity from that of the one or more first electrodes 421. As illustrated in FIG. 4C, the electrode assembly 420 may be provided through stacking in which the anodes 421a and 421b and the cathodes 422a, 422b, and 422c are alternately laminated, but the embodiment supported in the present disclosure is not limited thereto, and for example, the electrode assembly 420 may be provided through winding in which electrode stacks, to which an anode, a cathode, and a separator therebetween are coupled, are rolled. Unlike FIG. 4B, in case that the electrode assembly 420 has an irregular shape, a shape of the electrode assembly 420 may be provided through a stacking process. Unlike a winding process, the stacking process may easily process the shape of the electrode assembly 420 by processing and stacking the shapes of the one or more first electrodes 421, the one or more second electrodes 422, and the one or more separators 423, and then coupling the electrode tabs 432 and 442.

The electrode assembly 420 may include an electrode substrate and an electrode active material layer coated on the electrode substrate.

For example, each of the cathodes 422a, 422b, and 422c may include a cathode substrate and a cathode active material layer coated on the cathode substrate. The cathode substrate may be configured to collect an electron generated at the cathode active material layer according to an electrochemical reaction, or may provide an electron required for the electrochemical reaction to the cathode active material layer. For example, the cathode substrate may be configured to provide, by being electrically connected with the external circuit of the battery 370, the electron generated at the cathode active material layer to an external circuit during discharging, or provide the electron supplied through the external circuit to the cathode active material layer during charging. For example, the cathode substrate may include copper. The cathode substrate may be implemented in a form of a copper foil, but the embodiment supported in the present document is not limited thereto.

For example, each of the anodes 421a and 421b may include an anode substrate and an anode active material layer. The anode substrate may be used to supply an electron generated during a charging or discharging process to the outside or inside of the anode active material layer by being electrically connected with the external circuit of the battery 370. For example, the anode substrate may provide, by being electrically connected with the external circuit of the battery 370, the electron generated at the anode active material layer to the external circuit during charging, or may provide the electron supplied through the external circuit to the anode active material layer during discharging. For example, the anode substrate may include aluminum. The anode substrate may be implemented in a form of an aluminum foil, but the embodiment supported in the present document is not limited thereto.

For example, the separators 423a, 423b, 423c, and 423d may be disposed between one anode of the one or more first electrodes 421 and one cathode of the one or more second electrodes 422. For example, one or more separators 423 may provide a passage through which lithium ions can pass. The one or more separators 423 may prevent a physical contact (or a direct electrical short) between the one or more first electrodes 421 and the one or more second electrodes 422 having different electrical characteristics.

The battery 370 may include a first tab 430 extending from the one or more first electrodes 421, by penetrating the case 410, to the outside of the battery 370, and a second tab 440 extending from the one or more second electrodes 422, by penetrating the case 410, to the outside of the battery 370. For example, the first tab 430 and the second tab 440 may extend from the electrode assembly of the battery 370 to the outside of the battery 370 through the case 410, thereby forming a battery module or battery pack by being electrically connected with a circuit (e.g., a circuit on the first printed circuit board 250) outside the battery 370, or by being electrically connected with another battery. For example, the first tab 430 may electrically connect the one or more first electrodes 421 of the electrode assembly 420, and electronic components and/or circuits for power supply on the first printed circuit board 250 outside the battery 370. The second tab 440 may electrically connect the one or more second electrodes 422 of the electrode assembly 420, and the electronic components and/or the circuits for supplying power on the first printed circuit board 250 outside the battery 370. The electronic components and/or the circuits for supplying power may include power management circuitry, a charging circuitry (e.g., the charging circuitry 210 of FIG. 2), a power input pad, and/or a battery connector, but the embodiment supported in the present document is not limited thereto.

Although not illustrated, the battery 370 may include an electrolyte disposed within the case 410. The electrolyte may provide a passage through which lithium ions can move between the one or more first electrodes 421 and the one or more second electrodes 422. For example, the electrolyte may include a liquid electrolyte or a gel electrolyte. During charging, the lithium ions are deintercalated from the anode active material layer and may move to the cathode active material layer through the electrolyte and the one or more separators 423. The lithium ions moved to the cathode active material layer may be intercalated into the cathode active material layer while a reduction reaction occurs. An electron generated during the deintercalation process of the lithium ions may move to the cathode active material layer through the external circuit. For example, when the battery 370 is discharged, the lithium ions intercalated into the cathode active material layer are deintercalated and ionized into the electrolyte, and the ionized lithium ions may move to the anode active material layer through the electrolyte and the one or more separators 423. The electron generated at the cathode active material layer due to the deintercalation of the lithium ions may move to the anode active material layer through the external circuit. The lithium ions may be intercalated into the anode active material layer while meeting the electron and causing the reduction reaction. When the battery 370 is discharged, the electron passing through the external circuit may do work.

Since the battery 370 receives at least a portion of the heat emitted (transferred) from the electronic component 401 through the bracket 400, a performance of the battery 370 may be degraded by the heat. In particular, when the heat is transmitted to a portion of the tabs 430 and 440 directly connected to an active material in the electrode assembly 420, the performance of the battery 370 may be degraded by swelling by a chemical reaction of the active material. For example, in case that the tabs 430 and 440 extending from the electrode assembly 420 are connected to or in direct contact with the case 410, the heat is transmitted to the inside of the electrode assembly 420 connected to the tabs 430 and 440, thereby degrading the performance of the battery 370. The battery 370 not possessing a structure that improves a thermal stability of the battery 370 by electrically separating the tabs 430 and 440 connected to the active material of the electrode assembly 420 and the case 410, while guiding a position of the tabs 430 and 440 may be disadvantageous for improving the thermal stability. According to at least one embodiment of the disclosure given herein, the battery 370 comprises a structure that improves a thermal stability of the battery 370 by electrically separating the tabs 430 and 440 connected to the active material of the electrode assembly 420 and the case 410, while guiding a position of the tabs 430 and 440. Such structure may for example be described with respect to Figure 4B or Figure 5.

According to an embodiment, the battery 370 may include an insulation cover 450 disposed within the case 410, including a first through hole 451 penetrated by the first tab 430 and a second through hole 452 penetrated by the second tab 440 and spaced apart from the first through hole 451. The insulation cover 450 may electrically disconnect the first tab 430 and the second tab 440 from the case 410.

For example, the insulation cover 450 may be attached to an inner surface 410b of the case 410. The insulation cover 450 may separate the tabs 430 and 440 from the inner surface 410b by partially surrounding the tabs 430 and 440. For example, the insulation cover 450 may be disposed between the electrode assembly 420 and the inner surface 410b of the case 410. The insulation cover 450 may be coupled with the tabs 430 and 440 by passing the tabs 430 and 440 extending from the electrode assembly 420. The insulation cover 450 may guide the position of the tabs 430 and 440 within the case 410 or reduce a movement of the tabs 430 and 440, by being coupled with the tabs 430 and 440. For example, the insulation cover 450 may thermally and/or electrically insulate the tabs 430 and 440 from the case 410 by including a material (e.g., polyethylene, silicone, or rubber) with relatively low heat conductivity, i.e., thermal conductivity. However, the embodiment supported in the present disclosure is not limited thereto.

For example, the first through hole 451 may provide a passage for the first tab 430 to extend to the outside of the case 410, by enabling the first tab 430 to pass through. The second through hole 452 may provide a passage for the second tab 440 to extend to the outside of the case 410, by enabling the second tab 440 to pass through. By being spaced apart from each other, the through holes 451 and 452 may guide the position of the tabs 430 and 440 such that the tabs 430 and 440 are spaced apart from each other without being short-circuited. To maintain a separation distance between the tabs 430 and 440, the insulation cover 450 may have a structure that enables the tabs 430 and 440 to simultaneously pass through. Alternatively, the insulation cover 450 penetrated by the tabs 430 and 440 may implement a shape similar to the integrally formed insulation cover 450 by separately forming a structure that enables each of the tabs 430 and 440 to pass through and be fixed to each other.

The first tab 430 may include a first lead tab 431 that penetrates the case 410 and the first through hole 451 of the insulation cover 450 and is at least partially exposed to the outside of the battery 370, and a first electrode tab 432 connected to the first lead tab 431 within the case 410. The second tab 440 may include a second lead tab 441 that penetrates the case 410 and the second through hole 452 of the insulation cover 450 and is at least partially exposed to the outside of the battery 370, and a second electrode tab 442 connected to the second lead tab 441 within the case 410. The insulation cover 450 may guide a position between the first lead tab 431 and the second lead tab 441.

For example, the lead tabs 431 and 441 may be respectively connected with the electrode tabs 432 and 442, by passing through the case 410 and the insulation cover 450. For example, the lead tabs 431 and 441 may form a battery module or a battery pack by being electrically connected to a circuit outside the battery 370 or electrically connected to another battery, respectively. For example, the lead tabs 431 and 441 may include a conductive material (e.g., metal), such that power may be transmitted through the lead tabs 431 and 441.

For example, the first lead tab 431 may include a first connecting portion 431a positioned outside the battery 370, a second connecting portion 431b extending from the first connecting portion 431a toward the first electrode tab 432 within the case 410 by penetrating the case 410 and the first through hole 451 of the insulation cover 450. The second lead tab 432 may include a third connecting portion 441a positioned outside the battery 370 together with the first connecting portion 431a, and a fourth connecting portion 441b extending from the third connecting portion 441a toward the second electrode tab 442 within the case 410 by penetrating the case 410 and the second through hole 452 of the insulation cover 450. The connecting portions 431b and 441b of the lead tabs 431 and 441 respectively connected to the electrode tabs 432 and 442 by penetrating the case 410 and the insulation cover 450, may be thermally and/or electrically insulated from the case 410 through the insulation cover 450. The insulation cover 450 may be integrally formed to include the through holes 451 and 452 for passing through the connecting portions 431b and 441b, thereby guiding the position of the lead tabs 431 and 441 such that the lead tabs 431 and 441 are aligned with or coupled to the respectively corresponding electrode tabs 432 and 442, and preventing a short between the tabs 430 and 440.

For example, the first electrode tab 432 may be formed by laminating and/or coupling of anode tabs 432a and 432b extending from the anodes 421a and 421b. The second electrode tab 442 may be formed by laminating and/or coupling of cathode tabs 442a, 442b, and 442c extending from the cathodes 422a, 422b, and 422c. For example, the first electrode tab 432 may be coupled with the second connecting portion 431b of the first lead tab 431, penetrating the insulation cover 450 at the inside of the case 410. The second electrode tab 442 may be coupled with the fourth connecting portion 441b of the second lead tab 441, penetrating the insulation cover 450 at the inside of the case 410. For example, the electrode tabs 432 and 442 may be at least partially bent to be coupled with the respectively corresponding lead tabs 431 and 441. For example, the electrode tabs 432 and 442 may be electrically connected with the respectively corresponding lead tabs 431 and 441, e.g., through welding, but the embodiment supported by the present document is not limited thereto, and the electrode tabs 432 and 442 may be coupled with the respectively corresponding lead tabs 431 and 441 through various processes.

For example, when the battery 370 is discharged, the power provided from the electrode assembly 420 may be provided to the external circuit of the battery 370 sequentially connected with the lead tabs 431 and 441 through electrode tabs 432 and 442 and the lead tabs 431 and 441. When the battery 370 is charged, the power provided from the charging device may be sequentially transmitted to the electrode assembly 420 through the lead tabs 431 and 441 and the electrode tabs 432 and 442.

The battery 370 may include one or more insulators 460 disposed along an outer surface 410a of the case 410. For example, the battery 370 may include a first insulator 461 interposed between the case 410 and the first lead tab 431, and a second insulator 462 interposed between the case 410 and the second lead tab 441. For example, the first insulator 461 may electrically and/or thermally insulate the second connecting portion 431b of the first lead tab 431 from the case 410, by being disposed at least partially between the first plate 411 and the second plate 412 of the case 410. The second insulator 462 may electrically and/or thermally insulate the fourth connecting portion 432b of the second lead tab 432 from the case 410, by being disposed at least partially between the first plate 411 and the second plate 412 together with the first insulator 461. However, a disposition of the one or more insulators 460 is not limited to the embodiments supported in the present disclosure. For example, the first insulator 461 may electrically and/or thermally insulate the first lead tab 431 from the case 410, by being attached to the outer surface 410a of the case 410 and partially surrounds the first lead tab 431. The second insulator 462 may electrically and/or thermally insulate the second lead tab 432 from the case 410 by being attached to the outer surface 410a of the case 410 and partially surrounds the second lead tab 432.

As described above, the battery 370 of the electronic device 101 may include the insulation cover 450 and the one or more insulators 460 that electrically and/or thermally insulate the tabs 430 and 440 electrically connected with the external circuit of the battery 370 from the case 410, thereby improving the thermal stability of the battery 370 with respect to the heat transmitted from the electronic component 401 to the case 410, and reducing corrosion (e.g., galvanic corrosion) caused by a chemical reaction between the case 410 and the bracket 400. In addition to the structure of the battery 370 for insulating the tabs 430 and 440 from the case 410, in the electronic device 101, the absence of a structure of the case 410 of the battery 370 and/or a structure around the battery 370 may be a disadvantage for improving the heat dissipation performance. According to at least one embodiment of the disclosure given herein, such a structure is provided. The structure will be described through an exemplary diagram of FIG. 5.

FIG. 5 is a partial cross-sectional view of an exemplary electronic device cut along line A-A' of FIG. 4A.

Referring to FIG. 5, an electronic device 101 may include an electronic component 401, a printed circuit board 510 (e.g., the first printed circuit board 250 of FIG. 3B) on which the electronic component 401 is mounted, a bracket 400 on which the printed circuit board 510 is disposed, or a battery 370 spaced apart from the electronic component 401. The battery 370 may include a case 410 fastened to the bracket 400, an electrode assembly 420 disposed within the case, a first tab 430 extending from the electrode assembly 420 to the outside of the battery 370 by penetrating the case 410, a second tab (e.g., the second tab 440 of FIG. 4B) extending from the electrode assembly 420 to the outside of the battery 370 by penetrating the case 410, and an insulation cover 450, disposed within the case 410, including a first through hole (e.g., the first through hole 451 of FIG. 4B) penetrated by the first tab 430 and a second through hole (e.g., the second through hole 452 of FIG. 4B), penetrated by the second tab 440, spaced apart from the first through hole. The insulation cover 450 may electrically disconnect the first tab 430 and the second tab 440 from the case 410. However, an embodiment supported in the present disclosure is not limited thereto, and the electronic device 101 and/or the battery 370 exemplarily illustrated and described in FIG. 5 may include structures and/or configurations (e.g., the one or more first electrodes 421 connected with the first tab 430 and the one or more second electrodes 422 connected with the second tab 440) exemplarily illustrated and described in FIGS. 4A to 4C. Hereinafter, an overlapping description of configurations having the same reference numerals as those illustrated and described in FIGS. 4A to 4C may be omitted.

According to an embodiment, the case 410 may include a first metal layer 501 at least partially forming an outer surface 410a of the case 410, a second metal layer 502 at least partially forming an inner surface 410b of the case 410, and a third metal layer 503 disposed between the first metal layer 501 and the second metal layer 502. Heat conductivity, i.e., thermal conductivity of the third metal layer 503 may be greater than heat conductivity of the first metal layer 501 and heat conductivity of the second metal layer 502. In other words, the heat conductivity, i.e., thermal conductivity of the third metal layer 503 may be greater than either the heat conductivity of the first metal layer 501 or the heat conductivity of the second metal layer 502.

For example, the first metal layer 501 may be a layer coupled to the bracket 400 of the case 410 or attached to the bracket 400. The first metal layer 501 may be an outer-most layer of the case 410 forming an exterior of the case 410. For example, the outer surface 410a of the case 410 at least partially formed by the first metal layer 501 may be in contact with a first surface 400a of the bracket 400 facing the battery 370 or may be attached on the first surface 400a. For example, the first metal layer 501 may have a higher rigidity than the second metal layer 502 and/or the third metal layer 503 to reduce damage to the case 410 due to external impact, but the embodiment supported in the present disclosure is not limited thereto. In other words, higher rigidity may refer to the layer having a different thickness, a different density and/or a different mechanical stiffness. For example, in order to reduce corrosion of the case 410, the first metal layer 501 may have lower reactivity than the second metal layer 502 and the third metal layer 503, but the embodiment supported in the present disclosure is not limited thereto. In other words, reactivity may refer to a chemical reactivity or a propensity of a material to participate in a chemical or electrochemical reaction.

For example, the second metal layer 502 may be a layer surrounding internal components (e.g., the electrode assembly 420, or an electrolyte) of the battery 370. The second metal layer 502 may be an inner-most layer forming a space for the internal components of the battery 370. For example, the second metal layer 502 may be electrically and/or thermally insulated from tabs 430 and 440 by the insulation cover 450 as exemplarily described in FIGS. 4A to 4C. The insulation cover 450 may be attached or mounted on the inner surface 410b of the case 410 at least partially formed by the second metal layer 502. For example, in order to support the internal components of the battery 370, the second metal layer 502 may have a higher rigidity than the third metal layer 503 between the second metal layer 502 and the first metal layer 501, but the embodiment supported in the present document is not limited thereto.

For example, the third metal layer 503 may be interposed or formed between the first metal layer 501 and the second metal layer 502. The third metal layer 503 may be formed from a metal having different thermal properties and/or mechanical properties from the first metal layer 501 and the second metal layer 502. For example, thermal resistance of the third metal layer 503 may be lower than thermal resistance of the first metal layer 501 and/or thermal resistance of the second metal layer 502. For example, thermal diffusivity of the third metal layer 503 may be greater than thermal diffusivity of the first metal layer 501 and/or thermal diffusivity of the second metal layer 502. However, the embodiment supported in the present disclosure is not limited thereto. The case 410 may reduce damage to the internal components (e.g., the electrode assembly 420) of the battery 370 due to heat transmitted from the electronic component 401 to the case 410 and improve a heat dissipation performance of the battery 370, by including the first metal layer 501, the second metal layer 502, and the third metal layer 503 that has relatively high thermal conductivity therebetween, while also improving space efficiency.

For example, the first metal layer 501 and the second metal layer 502 may respectively include stainless steel. For example, the third metal layer 503 may include copper. However, the embodiment supported in the present disclosure is not limited thereto. For example, at least one of the metal layers 501, 502, and 503 may be omitted. For example, the first metal layer 501 may be omitted. The third metal layer 503 may be, for example, metal coating. However, the embodiment is not limited thereto.

For example, the case 410 may include a first plate 411 facing the bracket 400, and a second plate 412 coupled to the first plate 411. Heat conductivity, i.e., thermal conductivity of the first plate 411 may be greater than that of the second plate 412. For example, the first plate 411 may be formed from a metal with different thermal properties and/or mechanical properties from the second plate 412. For example, thermal resistance of the first plate 411 may be smaller than thermal resistance of the second plate 412. For example, thermal diffusivity of the first plate 411 may be greater than thermal diffusivity of the second plate 412. However, the embodiment supported in the present disclosure is not limited thereto.

For example, a stack structure of the metal layers 501, 502, and 503 may be formed on the first plate 411 of the first plate 411 and the second plate 412. For example, the first plate 411 may include the first metal layer 501 forming a portion of the outer surface 410a of the case 410, the second metal layer 502 forming a portion of the inner surface 410b of the case 410, and the third metal layer 503 disposed between the first metal layer 501 and the second metal layer 502. However, the embodiment supported in the present disclosure is not limited thereto. Since the case 410 of the battery 370 is formed such that thermal conductivity of the first plate 411 attached on the bracket 400 is greater than thermal conductivity of the second plate 412 coupled to the first plate 411, a heat dissipation performance of the battery 370 with respect to the heat transmitted from the electronic component 401 to the case 410 through the bracket 400 may be improved.

According to an embodiment, a first coupling portion 411a of the first plate 411 connected with the second plate 412 may be formed of substantially the same metal material as a second coupling portion 412a of the second plate 412 connected with the first plate 411. For example, the second plate 412 may be formed from substantially the same metal material as the second metal layer 502 of the first plate 411, which defines the first coupling portion 411a connected with the second plate 412. For example, the second metal layer 502 of the second plate 412 and the second coupling part 412a coupled with the second metal layer 502 may be formed from stainless steel. For example, the second metal layer 502 and the second plate 412 coupled with the second metal layer 502 may be integrally formed from the stainless steel, but the embodiment is not limited thereto. The case 410 may reduce damage of any one of the plates 411 and 412 due to different thermal conductivity by the heat transmitted from the electronic component 401 to the case 410 by forming portions in which the first plate 411 and the second plate 412 are coupled to each other from substantially the same metal.

For example, the first plate 411 and the second plate 412 may be different metals or metal layers having different configurations. The different metal layers may mean a stack of physically different metals or different surface treatments of substantially the same metal. The different surface treatments may mean increasing thermal resistance of the surface by corroding the surface of the metal, or coating the metal having high thermal conductivity.

Unlike as illustrated, the case 410 may be integrally formed from copper alloy. For example, as exemplarily illustrated in FIG. 4C, the first plate 411 and the second plate 412 may be provided through processing of an original plate formed from the copper alloy. However, the embodiment supported in the present disclosure is not limited thereto, and the case 410 may improve the heat dissipation performance of the battery 370 by being integrally formed from a metal and/or alloy having relatively high thermal conductivity with respect to the bracket 400.

For example, the electronic component 401 may be disposed on a surface 510a of the printed circuit board 510 facing toward the bracket 400. The electronic device 101 may include a shield can 520 disposed on the surface 510a and surrounding the electronic component 401. As an example, the shield can 520 may include an opening 525 formed over the electronic component 401. For example, the shield can 520 may shield the electronic component 401 by being coupled to the surface 510a of the printed circuit board 510 to which the electronic component 401 is coupled. The opening 525 of the shield can 520 may overlap the electronic component 401 when viewed from above (e.g., when viewed in a +z direction). The opening 525 may enable one or more first heat-conductive members 530 attached on the electronic component 401 to pass through. For example, the opening 525 may be a passage for at least a portion of the heat emitted (transferred) from the electronic component 401 to be dissipated through the one or more first heat-conductive members 530 disposed on the electronic component 401.

For example, the shield can 520 may be connected with a ground within the electronic device 101. For example, the shield can 520 may be electrically connected with the ground of the electronic device 101 through the printed circuit board 510. The shield can 520 may emit an electromagnetic wave emitted from the electronic component 401 to the ground by being connected with the ground. For example, one or more other electronic components 402 may be coupled on another surface 510b opposite to the surface 510a of the printed circuit board 510 to which the electronic component 401 is coupled. The shield can 520 can, for example, reduce a performance of the one or more other electronic components 402 around the electronic component 401 by emitting the electromagnetic wave to the ground.

For example, by being attached to the shield can 520, the electronic device 101 may include a shielding sheet 540 covering the opening 525 of the shield can 520, and the one or more first heat-conductive members 530 interposed between the electronic component 401 and the shielding sheet 540 through the opening 525. For example, the shielding sheet 540 may be disposed between the shield can 520 and the bracket 400 (or a vapor chamber 550). The shielding sheet 540 may be in contact with the one or more first heat-conductive members 530 that have passed through the opening 525. The shielding sheet 540 may shield the electronic component 401 together with the shield can 520 by covering the opening 525. For example, the shielding sheet 540 may be electrically connected with the shield can 520 by including a conductive material. The shielding sheet 540 may be configured to transmit an electromagnetic wave emitted from the electronic component 401 to the shield can 520 connected with the ground, but the embodiment is not limited thereto.

For example, the one or more first heat-conductive members 530 may be attached to the electronic component 401. The one or more first heat-conductive members 530 may be interposed between the electronic component 401 and the shielding sheet 540. The one or more first heat-conductive members 530 may be in contact with the shielding sheet 540 through the opening 525 of the shield can 520. For example, the one or more first heat-conductive members 530 may be in contact with the electronic components 401 and the shielding sheet 540. For example, the one or more first heat-conductive members 530 may transmit at least a portion of the heat emitted (transferred) from the electronic component 401 to the shielding sheet 540 and/or the bracket 400 on the one or more first heat-conductive members 530 through conduction heat transfer. For example, the one or more first heat-conductive members 530 may be fastened between the shielding sheet 540 and the electronic component 401 by being attached to the shielding sheet 540.

For example, the one or more first heat-conductive members 530 may penetrate at least a portion of the opening 525 of the shield can 520. For example, the one or more first heat-conductive members 530 may be attached to the shielding sheet 540 covering the opening 525 by passing through the opening 525. For example, the one or more first heat-conductive members 530 may provide a passage for the heat emitted (transferred) from the electronic component 401 to be transmitted to the shielding sheet 540 and the vapor chamber 550 through the opening 525. For example, the one or more first heat-conductive members 530 may include a material having relatively high thermal conductivity. The one or more first heat-conductive members 530 may be referred to as a thermal interface material (TIM) in terms of being interposed between the electronic component 401 and the shielding sheet 540, but are not limited thereto. The electronic device 101 may reduce a performance of the electronic component 401 surrounded by the shield can 520 from deteriorating due to the heat emitted (transferred) from the electronic component 401 by including the one or more first heat-conductive members 530 that transmit at least a portion of the heat emitted (transferred) from the electronic component 401 through the opening 525 of the shield can 520 to the shield sheet 540 and/or the vapor chamber 550.

For example, the bracket 400 may include a slit 405 formed on the battery 370. The electronic device 101 may include the vapor chamber 550 disposed on the bracket 400 and covering the slit 405, and one or more second heat-conductive members 560 at least partially interposed between the vapor chamber 550 and the case 410 of the battery 370 through the slit 405.

For example, the slit 405 of the bracket 400 may face the first plate 411 of the case 410 attached to the bracket 400. The slit 405 may be formed between the vapor chamber 550 and the first plate 411. For example, the slit 405 may provide a passage for a heat transfer path from the vapor chamber 550 to the case 410.

For example, the vapor chamber 550 may be disposed on a second surface 400b opposite to the first surface 400a of the bracket 400 to which the electronic component 401 and the battery 370 are attached. For example, the vapor chamber 500 may receive the heat emitted (transferred) from the electronic component 401 through conduction heat transfer by being attached on the second surface 400b. For example, the vapor chamber 550 may receive at least a portion of the heat emitted (transferred) from the electronic component 401 through the bracket 400. The vapor chamber 550 may reduce damage to the electronic component 401 due to the heat by diffusing the transmitted heat. For example, the vapor chamber 550 may transmit at least a portion of the heat received through the bracket 400 to the case 410 of the battery 370 through the slit 405 (or the one or more second heat-conductive members 560 interposed between the vapor chamber 550 and the case 410 through the slit 405). However, the embodiment supported in the present disclosure is not limited thereto, and although not illustrated, at least a portion of the vapor chamber 550 may be disposed over the electronic component 401 to at least partially overlap the electronic component 401.

For example, the one or more second heat-conductive members 560 may include a heat dissipation sheet 561, attached to the bracket 400 to cover the slit 405 of the bracket 400, contacting the case 410, and a heat dissipation material 562 disposed between the vapor chamber 550 and the heat dissipation sheet 561 to fill the slit 405. For example, the heat dissipation sheet 561 may be attached on the first surface 400a of the bracket 400 facing the battery 370. The heat dissipation sheet 561 may be, for example, surrounded by an adhesive member 570 for attaching the battery 370 on the first surface 400a. For example, the heat dissipation material 562 may fill a space between the heat dissipation sheet 561 and the vapor chamber 550. The heat dissipation material 562 may occupy the slit 405 of the bracket 400 by being interposed between the heat dissipation sheet 561 and the vapor chamber 550. For example, as illustrated, as the battery 370 is pressed on the bracket 400 through the adhesive member 570, the heat dissipation sheet 561 may be compressed toward the vapor chamber 550 by the case 410 of the battery 370. The heat dissipation material 562 between the heat dissipation sheet 561 and the vapor chamber 550 may occupy a space (or the slit 405) between the vapor chamber 550 and the heat dissipation sheet 561 by being spread by the compressed heat dissipation sheet 561. However, the embodiment supported in the present disclosure is not limited thereto. The electronic device 101 may improve the heat dissipation performance of the electronic device 101 for the heat emitted (transferred) from the electronic component 401 by including various configurations (e.g., the one or more first heat-conductive members 530, the shielding sheet 540, the bracket 400, the slit 405, the vapor chamber 550, or the one or more second heat-conductive members 560) for heat dissipation while forming a heat transfer path from the electronic component 401 to the battery 370.

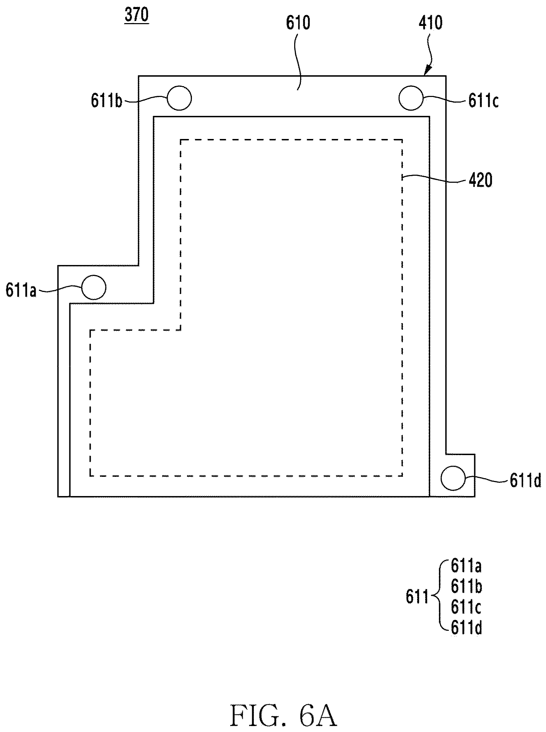

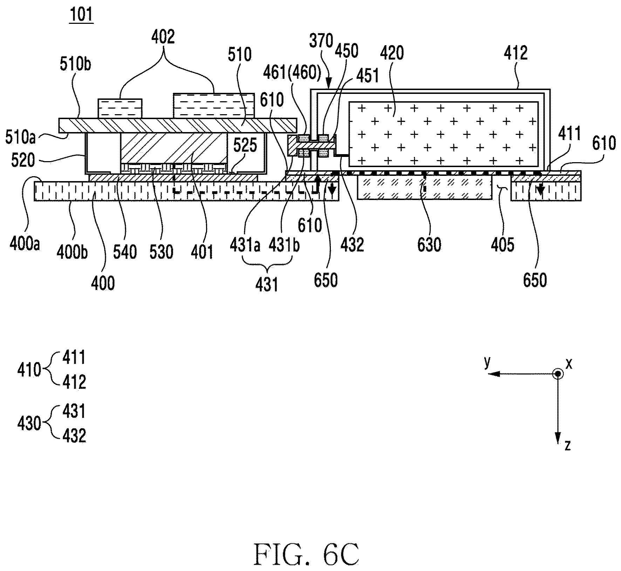

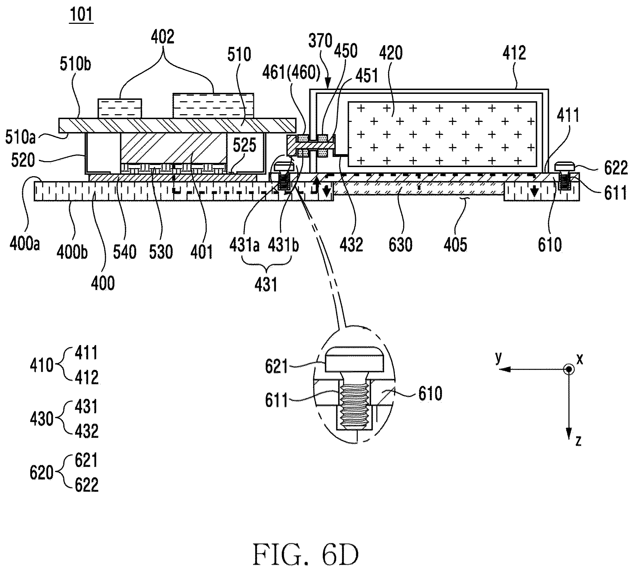

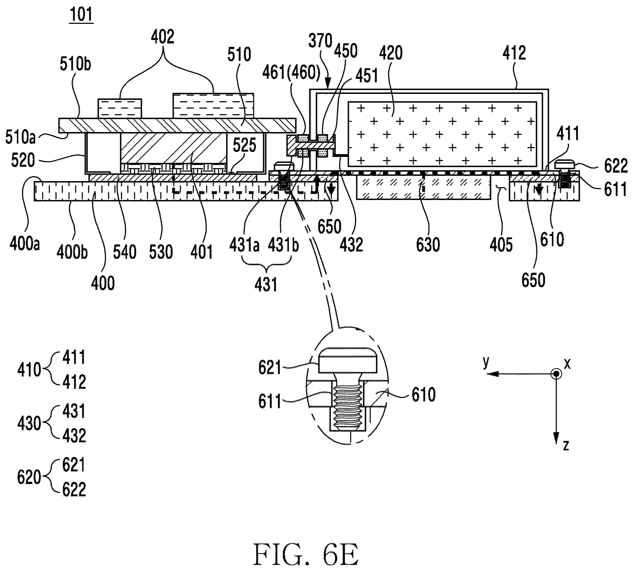

FIG. 6A is a top plan view of a battery of an exemplary electronic device. FIGS. 6B, 6C, 6D, and 6E illustrate an internal structure of an exemplary electronic device.

Referring to FIGS. 6A, 6B, 6C, 6D, and 6E, an electronic device 101 may include an electronic component 401, a bracket 400 disposed on the electronic component 401, or a battery 370 spaced apart from the electronic component 401. The battery 370 may include a case 410 fastened to the bracket 400, an electrode assembly 420 disposed within the case, a first tab 430 extending from the electrode assembly 420 to the outside of the battery 370 by penetrating the case 410, a second tab 440 (e.g., the second tab 440 of FIG. 4B) extending from the electrode assembly 420 to the outside of the battery 370, and an insulation cover 450, disposed within the case 410 and including a first through hole (e.g., the first through hole 451 of FIG. 4B) penetrated by the first tab, and a second through hole (e.g., the second through hole 452 of FIG. 4B), penetrated by the second tab, spaced apart from the first though hole 451. The insulation cover 450 may electrically disconnect the first tab 430 and the second tab 440 from the case 410. However, an embodiment supported in the present disclosure is not limited thereto, and the electronic device 101 and/or the battery 370 exemplarily illustrated and described in FIGS. 6A to 6D, may include, within a range that does not contradict, structures and/or configurations (e.g., the one or more first electrodes 421 connected to the first tab 430 and the one or more second electrodes 422 connected to the second tab 440, the slit 405, the metal layers 501,502, and 503 of the case 410, the printed circuit board 510, the shield can 520, the one or more first heat-conductive members 530, the shielding sheet 540, the vapor chamber 550, the one or more second heat-conductive members 560, or the adhesive member 570) exemplarily illustrated and described in FIGS. 4A to 5. Hereinafter, an overlapping description of configurations having the same reference numerals as those illustrated and described in FIGS. 4A to 5 may be omitted.

According to an embodiment, the case 410 of the battery 370 may include a flange 610 formed along a periphery of the case 410. For example, the flange 610 may increase extent for the case 410 to be coupled to the bracket 400 by protruding from a portion of the case 410. For example, the flange 610 may be formed on a first plate 411 among the first plate 411 and a second plate 412 of the case 410, but the embodiment supported in the present disclosure is not limited thereto, and the flange 610 may be formed through a portion where the first plate 411 and the second plate 412 are coupled or overlapped with each other.

According to an embodiment, the flange 610 may include one or more holes 611 penetrating the flange. For example, referring to FIG. 6A, the one or more holes 611 may include a plurality of holes 611a, 611b, 611c, and 611d formed along a periphery of the case 410. Referring to FIGS. 6B and 6D, the electronic device 101 may include a fastener 620 coupled to the bracket 400 such that the case 410 is contacting with the bracket 400 through the one or more holes 611. For example, the fastener 620 may compress the case 410 (or the flange 610 of the case 410) to the bracket 400 by being coupled to the bracket 400 through the one or more holes 611. For example, unlike illustrated in FIG. 5, since the case 410 is coupled to the bracket 400 through the fastener 620, the adhesive member 570 for attaching the battery 370 to the bracket 400 may be omitted. As the adhesive member 570 is omitted, the case 410 (or the first plate 411) of the battery 370 may be in direct contact with the bracket 400 through the fastener 620. By the contact, the case 410 may improve heat dissipation performance of the electronic device 101 by receiving heat from the bracket through conduction heat transfer. For example, the fastener 620 may fix the case 410 to the bracket 400 by including bolts 621 and 622 coupled to the one or more holes 611 to, but the embodiment is not limited thereto, and the electronic device 101 may improve the heat dissipation performance of the electronic device 101 by contacting the case 410 to the bracket 400 through various fastening members that couple the case 410 to the bracket 400 through the flange 610.

According to an embodiment, the fastener 620 may at least partially overlap the printed circuit board 510. For example, at least a portion of the flange 610 may be disposed over (e.g., in the +z-axis direction) the printed circuit board 510. The fastener 620 (or the first bolt 621) coupled to the at least portion of the flange 610 may at least partially overlap the printed circuit board 510 when viewed from above (e.g., viewed from +z direction) by being disposed over the printed circuit board 510. However, the embodiment supported in the present disclosure is not limited thereto. The fastener 620 may provide an additional space in the electronic device 101 for securing a capacity of the battery 370 between the battery 370 and the printed circuit board 510 by being disposed to at least partially overlap the printed circuit board 510.

The first plate 411 of the case 410 may have higher heat conductivity, i.e., thermal conductivity than the bracket 400. For example, in order to protect electronic components (e.g., the electronic components 401) mounted on the bracket 400, the bracket 400 may be formed of a material or a structure having a relatively higher rigidity than the case 410 of the battery 370. The case 410 may be formed of a material having a relatively higher heat conductivity than the bracket 400 in order to diffuse heat transferred from the bracket 400. However, the embodiment supported in the present disclosure is not limited thereto.

Referring to FIGS. 6C and 6D, the electronic device 101 may include a coil 630 disposed at least partially in the slit 405 of the bracket 400, used for wireless charging of the battery 370, instead of the vapor chamber 550. The case 410 of the battery 370 may be configured to form a heat transfer path from the coil 630 to the bracket 400. For example, the coil 630 may be configured to receive power from the outside (e.g., from the electronic device 102 of FIG. 1) of the electronic device 101. The coil 630 may supply the power to the battery 370 through the power transmitted from the outside. For example, the coil 630 may include a near field communication (NFC) antenna for wireless communication. For example, the coil 630 may be configured to receive information from the external electronic device 102 to the electronic device 101, or to transmit information from the electronic device 101 to the external electronic device 102, through a magnetic secure transmission. However, the embodiment supported in the present disclosure is not limited thereto.

For example, at least a portion of the coil 630 may be accommodated in the slit 405 of the bracket 400. For example, the coil 630 may be in direct and/or indirect contact with the case 410 of the battery 370 through the slit 405 or may be attached to the case 410. Heat emitted (transferred) from the coil 630 may be transmitted to the case 410 in contact with and/or attached to the coil 630. The case 410 may dissipate the heat by transmitting the heat transmitted from the coil 630, to the bracket 400 coupled to the case 410. However, the embodiment supported in the present disclosure is not limited thereto. The battery 370 (or the case 410 of the battery 370) may improve the heat dissipation performance of the electronic device 101 and provide a space for accommodating the coil 630 by diffusing the heat transmitted from the electronic component 401 and/or the coil 630 together with the bracket 400.

When referring to FIG. 6C, unlike as illustrated in FIG.5, the electronic device 101 may include one or more third heat-conductive members 650 that attach the case 410 to the bracket 400 instead of the adhesive member 570 and at least partially surround the coil 630. The one or more third heat-conductive members 650 may be configured to form a heat transfer path from the coil 630 to the bracket 400. For example, the one or more third heat-conductive members 650 may be interposed between the first plate 411 of the case 410 and the bracket 400. Heat transferred from the electronic component 401 to the bracket 400 may be diffused into the first plate 411 (or the case 410) through the one or more third heat-conductive members 650. For example, the heat transferred from the coil 630 to the first plate 411 (or the case 410) may diffuse to the bracket 400 through the one or more third heat-conductive members 650. For example, the one or more third heat-conductive members 650 may include a heat dissipation tape or a heat dissipation gel, and, unlike as illustrated, may be interposed between the case 410 and the bracket 400 together with the adhesive member 570 of FIG. 5, but the embodiment supported in the present disclosure is not limited thereto.

Referring to FIG. 6E, the case 410 of the battery 370 may be fixed on the bracket 400 through the third heat-conductive member 650 and the fastener 620. However, the embodiment supported in the present disclosure is not limited thereto.

A heat dissipation structure using the battery 370 and structures around the battery 370 illustrated and described in FIGS. 6A to 6E may be merely exemplary, and the electronic device 101 according to the examples supported in the present disclosure may include a combination of structures and/or configurations included in the examples illustrated and described in FIGS. 6A to 6D within a range that does not contradict.

As described above, an electronic device (e.g., the electronic device 101 of FIG. 1) may include a printed circuit board (e.g., the printed circuit board 510 of FIG. 5) including an electronic component (e.g., the processor 120 of FIG. 1 or the electronic component 401 of FIG. 4A), and a battery (e.g., the battery 189 of FIG. 1 or the battery 370 of FIG. 3B). The battery may include a metal can case (e.g., the case 410 of FIG. 4C) including a plate (e.g., the first plate 411 of FIG. 4C) and a cover (e.g., the second plate 412 of FIG. 4C) formed from a first metal material, and an electrode assembly (e.g., the electrode assembly 420 of FIG. 4C) disposed within the metal can case. The plate may include a first layer (e.g., the third metal layer 503 of FIG. 5) formed from a second metal material, and a second layer (e.g., the second metal layer 502 of FIG. 5), formed from at least the first metal material, disposed on the first layer, and facing the electrode assembly. In other words, the second layer may be located between the first layer and the electrode assembly, its first surface may physically interface the electrode assembly and its second surface may physically interface the first layer. Heat conductivity of the second metal material may be greater than heat conductivity of the first metal material, for dissipating heat generated by the electronic component, transmitted through a heat-conductive member by thermally contacting with the plate. The cover may be coupled to the plate by welding with the second layer of the plate.

For example, the electrode assembly may include first electrodes (e.g., the one or more first electrodes 421 of FIG. 4C), second electrodes (e.g., the one or more second electrodes 422 of FIG. 4C) having different polarity with respect to the first electrodes, a first electrode tab (e.g., the first electrode tab 432 of FIG. 4C) extending from the first electrodes within the metal can case, and a second electrode tab (e.g., the second electrode tab 442 of FIG. 4C) extending from the second electrodes within the metal can case. The electronic device may further comprise an insulation cover (e.g., the insulation cover 450 of FIG. 4C), disposed within the metal can case, insulating the first electrode tab and the second electrode tab from the metal can case.

For example, the insulation cover may include a first through hole (e.g., the first through hole 451 of FIG. 4C) aligned with the first electrode tab, and a second through hole (e.g., the second through hole 452 of FIG. 4C), spaced apart from the first through hole, aligned with the second electrode tab. The electronic device may further comprise a first lead tab (e.g., the first lead tab 441 of FIG. 4C), penetrating the metal can case and the first through hole of the insulation cover, connecting with the first electrode tab within the metal can case by being guided from the first through hole, and a second lead tab (e.g., the second lead tab 442 of FIG. 4C), penetrating the metal can case and the second through hole of the insulation cover, connecting with the second electrode tab within the metal can case by being guided from the second through hole.

For example, the plate may further include a third layer (e.g., the first metal layer 501 of FIG. 5) at least partially forming an outer surface (e.g., the outer surface 410a of FIG. 4B) of the plate, the second layer may be disposed between the first layer and the third layer. A rigidity of the third layer may be greater than a rigidity of the first layer.

For example, the third layer may be formed from at least the first metal material. The first metal material may comprise stainless steel, and the second metal material may comprise copper.

The heat-conductive member may include a heat-conductive bracket (e.g., the bracket 400 of FIG. 4A) disposed over the PCB and the battery, and a vapor chamber (e.g., the vapor chamber 550 of FIG. 5) disposed on the heat-conductive bracket to be disposed at least partially adjacent to the the battery. In other words, the bracket may be disposed at least partially over or under or on the side of the battery. The vapor chamber may be configured to spread the heat received from the heat-conductive bracket to the metal can case.

For example, the heat-conductive bracket may include a slit (e.g., the slit 405 in FIG. 5) formed between the vapor chamber and the plate of the metal can case. The heat-conductive member may further include a heat dissipation material (e.g., the heat dissipation material 562 in FIG. 5) interposed between the vapor chamber and the plate through the slit.

For example, the heat-conductive member may further include a heat dissipation sheet (e.g., the heat dissipation sheet 561 of FIG. 5), attached to the plate of the metal can case, compressing the heat dissipation material such that the heat dissipation material is positioned between the vapor chamber and the plate within the slit.

For example, the first metal material forming the cover may comprise copper alloy.

For example, the cover may include a recess (e.g., the recess 415 of FIG. 4C) forming an inner space to accommodate the electrode assembly.

For example, the metal can case may further include a flange (e.g., the flange 610 of FIG. 6A), formed along a periphery of the metal can case, including a hole (e.g., the hole 611 of FIG. 6A). The electronic device may further comprise a fastener (e.g., the fastener 620 of FIG. 6B), penetrating through the hole, coupled to a portion of the heat-conductive member such that the metal can case is contacting with the portion of the heat-conductive member.

For example, the fastener may at least partially overlap the PCB.

For example, the heat-conductive member may include a heat-conductive bracket including a slit formed adjacent to the battery. In other words, the slit may be disposed at least partially over or under or on the side of the battery. The electronic device may further comprise a coil (e.g., the coil 630 of FIG. 6C), disposed at least partially in the slit, used for wireless charging of the battery. The metal can case may be configured to form a heat transfer path from the coil to the bracket.

For example, the heat conductive member may further include a heat-conductive adhesive (e.g., the one or more third heat-conductive members 650 of FIG. 6C), attaching the metal can case to the heat-conductive bracket, at least partially surrounding the coil, and configured to form the heat transfer path.

For example, the heat conductive member may further include a heat conductive sheet (e.g., the shielding sheet 540 of FIG. 5) at least partially interposed between the heat-conductive bracket and the electronic component.

As described above, an electronic device (e.g., the electronic device 101 of FIG. 1) may include a heat generating component (e.g., the processor 120 of FIG. 1, or the electronic component 401 of FIG. 4A), a bracket (e.g., the frame structure 340 of FIG. 3B, or the bracket 400 of FIG. 4A) disposed on the heat generating component, and a battery (e.g., the battery 189 of FIG. 1 or the battery 370 of FIG. 3B) spaced apart from the heat generating component. The battery may include a case (e.g., the case 410 of FIG. 4A) fastened to the bracket, an electrode assembly (e.g., the electrode assembly 420 of FIG. 4C) including one or more first electrodes (e.g., the one or more first electrodes 421 of FIG. 4C) disposed in the case and one or more second electrodes (e.g., the one or more second electrodes 422 of FIG. 4C) having different polarity with respect to the one or more first electrodes, a first tab (e.g., the first tab 430 of FIG. 4B) extending from the one or more first electrodes of the electrode assembly, through the case, to the outside of the battery, a second tab (e.g., the second tab 440 of FIG. 4B) extending from the one or more second electrodes of the electrode assembly, through the case, to the outside of the battery, and an insulation cover (e.g., the insulation cover 450 of FIG. 4B), disposed within the case, including a first through hole (e.g., the first through hole 451 of FIG. 4B) penetrated by the first tab and a second through hole (e.g., the second through hole 452 of FIG. 4B), penetrated by the second tab, spaced apart from the first thought hole. The insulation cover may electrically disconnect the first tab and the second tab from the case.

For example, the first tab may include a first lead tab (e.g., the first lead tab 431 of FIG. 4B), penetrating the case and the first through hole, at least partially exposed to the outside of the battery, and a first electrode tab (e.g., the first electrode tab 432 of FIG. 4B) connected to the first lead tab within the case. The second tab may include a second lead tab (e.g., the second lead tab 441 of FIG. 4B), penetrating the case and the second through hole, at least partially exposed to the outside of the battery, and a second electrode tab (e.g., the second electrode tab 442 of FIG. 4B) connected to the second lead tab within the case. The insulation cover may guide a position between the first lead tab and the second lead tab.

For example, the battery may further include a first insulator (e.g., the first insulator 461 of FIG. 4B) interposed between the case and the first lead tab, and a second insulator (e.g., the second insulator 462 of FIG. 4B) interposed between the case and the second lead tab.

For example, the case may include a first metal layer (e.g., the first metal layer 501 of FIG. 5) at least partially forming an outer surface of the case (e.g., the outer surface 410a of FIG. 4B), a second metal layer (e.g., the second metal layer 502 of FIG. 5) at least partially forming an inner surface (e.g., the inner surface 410b of FIG. 4B) of the case, and a third metal layer (e.g., the third metal layer 503 of FIG. 5) disposed between the first metal layer and the second metal layer. Heat conductivity of the third metal layer 503 may be greater than heat conductivity of the first metal layer and heat conductivity of the second metal layer.

For example, the first metal layer and the second metal layer may include stainless steel. The third metal layer may include copper.

For example, the case may be integrally formed from copper alloy.

For example, the case may include a first plate (e.g., the first plate 411 of FIG. 4C) facing the bracket and a second plate (e.g., the second plate 412 of FIG. 4C), coupled to the first plate, including a recess (e.g., the recess 415 of FIG. 4C) that accommodates the electrode assembly. Heat conductivity of the first plate may be greater than heat conductivity of the second plate.

For example, a portion of the first plate connected to the second plate may be formed from substantially the same metal material with a portion of the second plate connected to the first plate.

For example, the case may include a flange (e.g., the flange 610 of FIG. 6A), formed along a periphery of the case, including a hole (e.g., the one or more holes 611 of FIG. 6A). The electronic device may further include a fastener (e.g., the fastener 620 of FIG. 6B), penetrating the hole, being coupled to the bracket, such that the case is contacting with the bracket.

For example, the electronic device may further include a printed circuit board (e.g., the first printed circuit board 350 of FIG. 3B, or the printed circuit board 510 of FIG. 5) on which the heat generating component is mounted. The fastener may at least partially overlap the printed circuit board.

For example, the bracket may include a slit (e.g., slit 405 of FIG. 5) formed adjacent to the battery. The electronic device may include a vapor chamber (e.g., the vapor chamber 550 of FIG. 5), disposed on the bracket, covering the slit, and one or more first heat-conductive members (e.g., the one or more second heat-conductive members 560 of FIG. 5) at least partially interposed between the vapor chamber and the case through the slit.

For example, the one or more first heat-conductive members may include a heat dissipation sheet (e.g., the heat dissipation sheet 561 of FIG. 5) attached to the bracket to cover the slit and in contact with the case, and a heat dissipation material (e.g., the heat dissipation material 562 of FIG. 5) disposed between the vapor chamber and the heat dissipation sheet to fill the slit.

For example, the bracket may include the slit formed adjacent to the battery. The electronic device may further include a coil (e.g., the coil 630 of FIG. 6C), at least partially disposed within the slit, used for wireless charging of the battery. The case may be configured to form a heat transfer path from the coil to the bracket.

For example, the electronic device may include one or more second heat-conductive members (e.g., the one or more third heat-conductive members 650 of FIG. 6C) attach the case to the bracket, at least partially surround the coil, and configured to form the heat transfer path.

For example, the electronic device may further include one or more third heat-conductive members (e.g., the one or more first heat-conductive members 530 of FIG.5) at least partially interposed between the heat generating component and the bracket.

As described above, the electronic device may include a heat generating component, a bracket disposed on the heat generating component, and a battery spaced apart from the heat generating component. The battery may include a case including a first plate facing the bracket and a second plate coupled to the first plate, and an electrode assembly disposed within the case. The first plate may include a first metal layer at least partially forming an outer surface of the case, a second metal layer at least partially forming an inner surface of the case, and a third metal layer disposed between the first metal layer and the second metal layer. Heat conductivity of the third metal layer may be greater than hear conductivity of the first metal layer and heat conductivity of the second metal layer. Heat conductivity of the second metal material may be greater than heat conductivity of the first metal material, for dissipating heat, generated by the electronic component, transmitted through a heat-conductive member by thermally contacting with the plate. In other words, heat conductivity of the second metal material may be greater than heat conductivity of the first metal material, wherein the second material may be configured for dissipating heat generated by the electronic component and transmitted through a heat-conductive member by thermally contacting the plate. Put differently, heat conductivity of the second metal material may be greater than heat conductivity of the first metal material, wherein the first layer may be configured for dissipating heat generated by the electronic component by transmitting the heat through a heat-conductive member that is thermally contacting with the plate.

For example, the second plate may be formed from substantially the same metal material with the second metal layer connected to the second plate.

For example, the first metal layer and the second metal layer may include stainless steel. The third metal layer may include copper.

The bracket may include a slit formed adjacent to the battery. The electronic device may further include a coil at least partially disposed within the slit and used for wireless charging of the battery. The case may be configured to form a heat transfer path from the coil to the bracket.

For example, the case may include a flange formed along a periphery of the case and including a hole. The electronic device may further include a fastener, penetrating the hole, coupled to the bracket, such that the case is contacting with the bracket, and a printed circuit board on which the heat generating component is mounted. The fastener may at least partially overlap the printed circuit board.

For example, the heat-conductive member may further include a heat dissipation sheet, attached to the plate of the metal can case, pressing the heat dissipation material such that the heat dissipation material is positioned between the vapor chamber and the plate within the slit.

For example, the heat-conductive member may further include a heat-conductive bracket including a slit formed over the battery.

The electronic device may include an insulation cover disposed within the metal can case, electrically disconnecting the first electrode tab and the second electrode tab from the metal can case, wherein the insulation cover includes a first through hole aligned with the first electrode tab and a second through hole, spaced apart from the first through hole, aligned with the second electrode tab.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a printed circuit board,PCB, (510) including an electronic component (120; 401); and
a battery (189; 370) comprising:
a metal can case (410) including:
a plate (411); and
a cover (412) coupled to the plate (411), the cover (412) formed from a first metal material, and
an electrode assembly (420), disposed within the metal can case (410),
wherein the plate (411) includes:
a first layer (503) formed from a second metal material; and
a second layer (502), formed from at least the first metal material, disposed on the first layer (503), and facing the electrode assembly (420), and
wherein heat conductivity of the second metal material is greater than heat conductivity of the first metal material, for dissipating heat, generated by the electronic component (120; 401), transmitted through a heat-conductive member by thermally contacting with the plate (411), and
wherein the cover (412) is coupled to the plate (411) by welding with the second layer (502) of the plate (411).

2. The electronic device (101) of claim 1,
wherein the electrode assembly (420) includes:
first electrodes (421);
second electrodes (422) having different polarity with respect to the first electrodes (421);
a first electrode tab (432) extending from the first electrodes (421) within the metal can case (410); and
a second electrode tab (442) extending from the second electrodes (422) within the metal can case (410),
wherein the electronic device (101) further comprises an insulation cover (450), disposed within the metal can case (410), electrically disconnecting the first electrode tab (432) and the second electrode tab (442) from the metal can case (410).

3. The electronic device (101) of claim 2,
wherein the insulation cover (450) includes:
a first through hole (451) aligned with the first electrode tab (432); and
a second through hole (452), spaced apart from the first through hole (451), and aligned with the second electrode tab (442),
wherein the electronic device (101) further comprises:
a first lead tab (431), penetrating the metal can case (410) and the first through hole (451) of the insulation cover (450), connecting with the first electrode tab (432) within the metal can case (410) by being guided from the first through hole (451); and
a second lead tab (441), penetrating the metal can case (410) and the second through hole (452) of the insulation cover (450), connecting with the second electrode tab (442) within the metal can case (410) by being guided from the second through hole (452).

4. The electronic device (101) of any one of claims 1 to 3,
wherein the plate (411) further includes a third layer (501) at least partially defining an outer surface (410a) of the plate (411),
wherein the second layer (502) is disposed between the first layer (503) and the third layer (501), and
wherein a rigidity of the third layer (501) is greater than a rigidity of the first layer (503).

5. The electronic device (101) of claim 4,
wherein the third layer (501) is formed from at least the first metal material,
wherein the first metal material comprises stainless steel, and
wherein the second metal material comprises copper.

6. The electronic device (101) of any one of claims 1 to 5,
wherein the heat-conductive member includes:
a heat-conductive bracket (340; 400) disposed over the PCB (510) and the battery (189; 370); and
a vapor chamber (550) disposed on the heat-conductive bracket (340; 400) to be disposed at least partially adjacent to the battery (189; 370),
wherein the vapor chamber (550) is configured to spread the heat received from the heat-conductive bracket (340; 400) to the metal can case (410).

7. The electronic device (101) of claim 6,
wherein the heat-conductive bracket (340; 400) includes a slit (405) formed between the vapor chamber (550) and the plate (411) of the metal can case (410), and
wherein the heat-conductive member further includes a heat dissipation material (562) interposed between the vapor chamber (550) and the plate (411) through the slit (405).

8. The electronic device (101) of claim 7,
wherein the heat-conductive member further includes a heat dissipation sheet (561), attached to the plate (411) of the metal can case (410), compressing the heat dissipation material (562) such that the heat dissipation material (562) is positioned between the vapor chamber (550) and the plate (411) within the slit (405).

9. The electronic device (101) of any one of claims 1 to 8,
wherein the first metal material forming the cover (412) comprises copper alloy.

10. The electronic device (101) of any one of claims 1 to 9,
wherein the cover (412) includes a recess (415) forming an inner space of the metal can case (410) to accommodate the electrode assembly (420).

11. The electronic device (101) of any one of claims 1 to 10,
wherein the metal can case (410) further includes a flange (610), formed along a periphery of the metal can case (410), including a hole (611),
wherein the electronic device (101) further comprises a fastener (620), penetrating through the hole (611), coupled to a portion of the heat-conductive member such that the metal can case (410) is contacting with the portion of the heat-conductive member.

12. The electronic device (101) of claim 11,
wherein the fastener (620) at least partially overlaps the PCB (510).

13. The electronic device (101) of any one of claims 1 to 12,
wherein the heat-conductive member includes a heat-conductive bracket (340; 400) including a slit (405) formed adjacent to the battery (189; 370),
wherein the electronic device (101) further comprises a coil (630), disposed at least partially in the slit (405), used for wireless charging of the battery (189; 370),
wherein the metal can case (410) is configured to form a heat transfer path from the coil (630) to the heat-conductive bracket (340; 400).

14. The electronic device (101) of claim 13,
wherein the heat conductive member further includes a heat-conductive adhesive (650), attaching the metal can case (410) to the heat-conductive bracket (340; 400), at least partially surrounding the coil (630), configured to form the heat transfer path.

15. The electronic device (101) of claim 13,
wherein the heat conductive member further includes a heat-conductive sheet (540) at least partially interposed between the heat-conductive bracket (340; 400) and the electronic component (120; 401).
